# EUROPEAN PATENT APPLICATION

(11) **EP 2 439 784 A1**
(43) Date of publication of application: **11.04.2012**
(21) Application number: 10794007.4
(22) Date of filing: 18.06.2010
(51) Int. Cl.: H01L 31/042

(54) **SOLAR BATTERY CELL WITH WIRING SHEET, SOLAR BATTERY MODULE, AND METHOD FOR PRODUCING SOLAR BATTERY CELL WITH WIRING SHEET**

(30) Priority: 02.07.2009 JP 2009157803
(71) Applicant: Sharp Kabushiki Kaisha, Osaka-shi, Osaka 545-8522 (JP)
(72) Inventor: NISHINA, Tomohiro, Osaka 545-8522 (JP); SAINOO, Yasushi, Osaka 545-8522 (JP); TSUNEMI, Akiko, Osaka 545-8522 (JP); DOTTA, Yoshihisa, Osaka 545-8522 (JP)
(74) Representative: Müller-Boré & Partner Patentanwälte
(86) International application number: PCT/JP2010/060354
(87) International publication number: WO 2011/001837

(57) **Abstract**

Disclosed are a solar cell with an interconnection sheet, wherein at least either of the connection between a first conductive electrode (6) of a back electrode type solar cell (8) and a first conductive wire (12) of an interconnection sheet (10) and the connection between a second conductive electrode (7) of the back electrode type solar cell (8) and a second conductive wire (13) of the interconnection sheet (10) is electrically established by a conductive substance (20), and the conductive substance (20) contains a metal which is in contact with at least either of the electrodes (6, 7) and the wires (12, 13) without metal bonding, a solar cell module containing the solar cell with an interconnection sheet, and a method for producing the solar cell with an interconnection sheet.

## Description

### TECHNICAL FIELD

The present invention relates to a solar cell with an interconnection sheet, a solar cell module and a method for producing a solar cell with an interconnection sheet.

### BACKGROUND ART

In recent years, development of clean energy has been awaited due to the problem of exhaustion of energy resources and the global environmental problem such as increase in the quantity of CO₂ in the atmosphere, and photovoltaic power generation employing particularly a solar cell has been developed and practicalized as a new energy source, and is in the process of development.

As to a solar cell, a bifacial solar cell produced by diffusing an impurity having a conductivity type opposite to the conductivity type of a silicon substrate into a photoreceiving surface of a single-crystalline or polycrystalline silicon substrate thereby forming a p-n junction and forming electrodes on the photoreceiving surface of the silicon substrate and the back surface of the silicon substrate opposite to the photoreceiving surface respectively has been mainstreamed in general. In the bifacial solar cell, it has also become general to attain a high output with a back surface field effect by diffusing an impurity of the same conductivity type as the silicon substrate into the back surface of the silicon substrate in a high concentration.

Further, a solar cell provided with an interconnection sheet (solar cell with an interconnection sheet) obtained by setting a back electrode type solar cell prepared by forming electrodes only on a back surface of a silicon substrate without forming electrodes on a photoreceiving surface of the silicon substrate on an interconnection sheet is also in the process of research and development (refer to Patent Literature 1, for example).

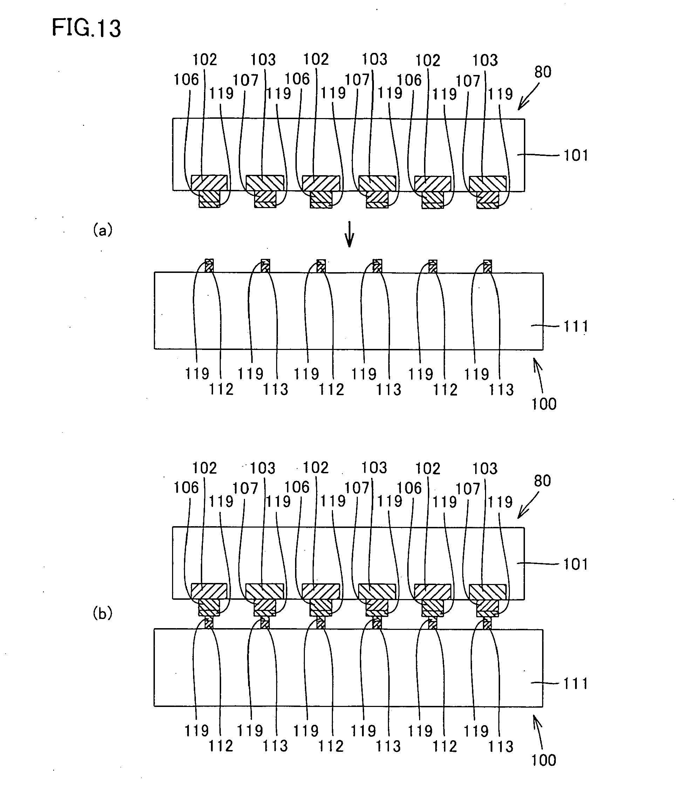

A conventional method for producing a solar cell with an interconnection sheet is now described with reference to schematic sectional views of Figs. 13(a) and 13(b).

First, a back electrode type solar cell 80 is set on an interconnection sheet 100, as shown in Fig. 13(a).

Solders 119 formed on surfaces of p electrodes 106 in contact with p⁺ layers 102 on the back surface of n-type silicon substrate 101 of back electrode type solar cell 80 are set on solders 119 formed on p wires 112 formed on a glass epoxy substrate 111 of interconnection sheet 100, while solders 119 formed on surfaces of n electrodes 107 in contact with n⁺ layers 103 on the back surface of n-type silicon substrate 101 of back electrode type solar cell 80 are set on solders 119 formed on surfaces of n wires 113 formed on glass epoxy substrate 111 of interconnection sheet 100.

Then, hot air is sprayed from the side of back electrode type solar cell 80 to melt solders 119 of both members and to thereafter cool the same, so that p electrodes 106 of back electrode type solar cell 80 and p wires 112 of interconnection sheet 100 are connected with each other by solders 119 while n electrodes 107 of back electrode type solar cell 80 and n wires 113 of interconnection sheet 100 are connected with each other by solders 119 as shown in Fig. 13(b), whereby back electrode type solar cell 80 and interconnection sheet 100 are integrated with each other and the solar cell with an interconnection sheet is prepared.

The solar cell with an interconnection sheet prepared in the aforementioned manner is sealed in transparent resin such as EVA (ethylene vinyl acetate), to form a solar cell module.

### CITATION LIST

### PATENT LITERATURE

PTL 1: Japanese Patent Laying-Open No. 2005-340362

### SUMMARY OF INVENTION

### TECHNICAL PROBLEM

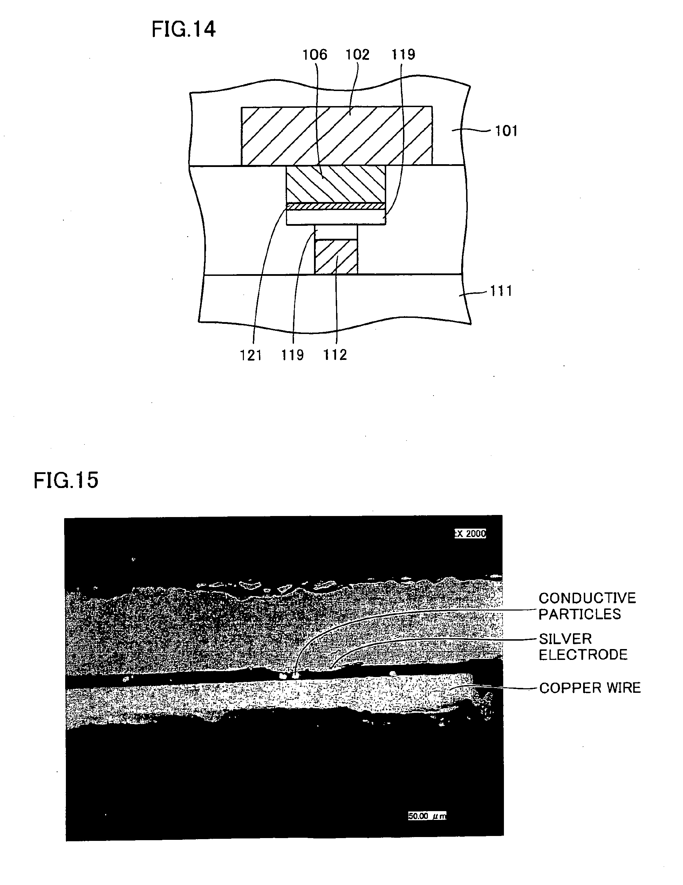

In a case of forming metallic bonds by solders 119 between the electrodes of back electrode type solar cell 80 and the wires of interconnection sheet 100 by employing solder such as Sn-Bi-based solder containing tin as solders 119, however, tin diffuses from solders 119 into p-type silver electrodes 106 and n-type silver electrodes 107 from solders 119 due to heat generated in driving of the solar cell module or temperature rise of the solar cell module caused by solar heat, and an alloy layer 121 of silver and tin is formed on the surface of each p-type silver electrode 106 as shown in a schematic enlarged sectional view of Fig. 14, for example.

There has been such a problem that, when the diffusion of tin further progresses and alloy layer 121 of silver and tin reaches a contact region which is a region where p-type silver electrode 106 comes into contact with p⁺ layer 102 on the back side of n-type silicon substrate 101, contact resistance between p-type silver electrode 106 and p⁺ layer 102 increases and the characteristics of the solar cell with an interconnection sheet and the solar cell module lower. While Fig. 14 shows only the case of p-type silver electrode 106, it goes without saying that a similar phenomenon takes place also in n-type silver electrodes 107.

Alloy layer 121 of silver and tin resulting from the aforementioned diffusion of tin enlarges in an early stage, and hence it has been required to ensure reliability of the solar cell module longer.

In order to prevent tin in solders 119 from diffusing into the silver electrodes, a method of electrically connecting the electrodes of back electrode type solar cell 80 and the wires of interconnection sheet 100 with each other by direct contact forming no metallic bonds without employing solders 119 is also conceivable.

However, there has been such a problem that, when performing electrical connection by bringing connecting the electrodes of back electrode type solar cell 80 and the wires of interconnection sheet 100 into direct contact with each other, it becomes difficult to ensure contact areas since the contact areas between the electrodes and the wires depend on the surface shapes of the electrodes and/or the wires, and these contact areas decrease.

In consideration of the aforementioned circumstances, an object of the present invention is to provide a solar cell with an interconnection sheet capable of ensuring reliability longer, a solar cell module and a method for producing a solar cell with an interconnection sheet.

### SOLUTION TO PROBLEM

The present invention provides a solar cell with an interconnection sheet including a back electrode type solar cell and an interconnection sheet, while the back electrode type solar cell includes a semiconductor substrate as well as a first conductivity type electrode and a second conductivity type electrode set on one surface side of the semiconductor substrate, the interconnection sheet includes an insulating substrate as well as a first conductivity type wire and a second conductivity type wire set on one surface side of the insulating substrate, at least either the first conductivity type electrode and the first conductivity type wire or the second conductivity type electrode and the second conductivity type wire are electrically connected with each other by a conductive substance, and the conductive substance contains a metal coming into contact with at least either the electrode or the wire without metallic bonding.

In the solar cell with an interconnection sheet according to the present invention, the conductive substance preferably contains at least one type selected from a group consisting of aggregating conductive particles, a hardened substance of a melt of aggregating conductive particles and a conductive film.

In the solar cell with an interconnection sheet according to the present invention, the hardness of the conductive substance is preferably lower than the hardness of at least one selected from a group consisting of the first conductivity type electrode, the second conductivity type electrode, the first conductivity type wire and the second conductivity type wire.

In the solar cell with an interconnection sheet according to the present invention, the conductive substance preferably contains at least either one of tin and bismuth.

In the solar cell with an interconnection sheet according to the present invention, insulating resin is preferably set between the back electrode type solar cell and the interconnection sheet.

Further, the present invention provides a solar cell module including any solar cell with an interconnection sheet described above.

In addition, the present invention provides a method for producing a solar cell with an interconnection sheet including a back electrode type solar cell including a first conductivity type electrode and a second conductivity type electrode set on one surface side of a semiconductor substrate and an interconnection sheet including a first conductivity type wire and a second conductivity type wire set on one surface side of an insulating substrate, including the steps of applying insulating resin containing conductive particles to a surface of the first conductivity type wire and a surface of the second conductivity type wire of the interconnection sheet respectively, setting the first conductivity type electrode of the back electrode type solar cell on the first conductivity type wire of the interconnection sheet while setting the second conductivity type electrode of the back electrode type solar cell on the second conductivity type wire of the interconnection sheet, and electrically connecting at least either the first conductivity type electrode and the first conductivity type wire or the second conductivity type electrode and the second conductivity type wire with each other by the conductive particles coming into contact with either the electrode or the wire without metallic bonding by applying pressure to at least either the back electrode type solar cell or the interconnection sheet.

### ADVANTAGEOUS EFFECTS OF INVENTION

According to the present invention, a solar cell with an interconnection sheet capable of ensuring reliability longer, a solar cell module and a method for producing a solar cell with an interconnection sheet can be provided.

### BRIEF DESCRIPTION OF DRAWINGS

Fig. 1 is a schematic sectional view of an example of a solar cell module according to the present invention.
Figs. 2(a) to 2(g) are schematic sectional views illustrating an example of a method for producing a back electrode type solar cell shown in Fig. 1.
Fig. 3 is a schematic plan view of an example of the back surface of the back electrode type solar cell shown in Fig. 1.
Figs. 4(a) to 4(d) are schematic sectional views illustrating an example of a method for producing an interconnection sheet shown in Fig. 1.
Fig. 5 is a schematic plan view of an example of a surface of an interconnection sheet employed in the present invention.
Figs. 6(a) to 6(c) are schematic sectional views illustrating an example of a method for producing a solar cell with an interconnection sheet employed for the solar cell module shown in Fig. 1.
Figs. 7(a) to 7(c) are schematic enlarged sectional views illustrating an example of an electrical connection method for a first conductivity type electrode of the back electrode type solar cell and a first conductivity type wire of the interconnection sheet.
Fig. 8 is a schematic sectional view of another example of the solar cell module according to the present invention.
Fig. 9 is a schematic sectional view of still another example of the solar cell module according to the present invention.
Fig. 10 is a diagram showing a temperature profile of heat treatment in Example 1.
Fig. 11(a) is a microphotograph of connected portions of a silver electrode of a back electrode type solar cell and a copper wire of an interconnection sheet in a solar cell with an interconnection sheet according to Example 1, and Fig. 11(b) is a microphotograph enlarging a portion surrounded by a white line in (a).
Fig. 12(a) is a microphotograph of connected portions of a silver electrode of a back electrode type solar cell and a copper wire of an interconnection sheet in a solar cell with an interconnection sheet according to comparative example, and Fig. 12(b) is a microphotograph enlarging the vicinity of a portion surrounded by a white line in (a).
Figs. 13(a) and 13(b) are schematic sectional views illustrating a conventional method for producing a solar cell with an interconnection sheet.
Fig. 14 is a schematic enlarged sectional view in the vicinity of a p-type silver electrode of the solar cell with an interconnection sheet shown in Fig. 13.
Fig. 15 is a microphotograph of connected portions of a silver electrode of a back electrode type solar cell and a copper wire of an interconnection sheet in a solar cell with an interconnection sheet according to Example 2.

### DESCRIPTION OF EMBODIMENTS

Embodiments of the present invention are now described. In the drawings of the present invention, it is assumed that identical reference signs express identical portions or corresponding portions.

### <First Embodiment>

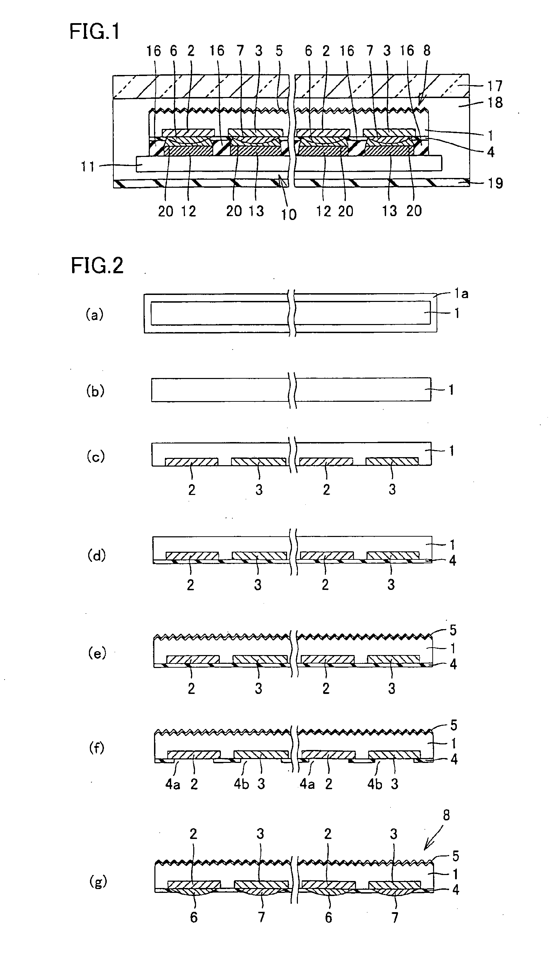

Fig. 1 shows a schematic sectional view of an example of a solar cell according to the present invention. In the solar cell module of the structure shown in Fig. 1, a solar cell with an interconnection sheet having such a structure that a back electrode type solar cell 8 is set on an interconnection sheet 10 is sealed in a sealing material 18 such as ethylene vinyl acetate between a transparent substrate 17 such as a glass substrate and a back film 19 such as a polyester film.

A concavo-convex structure such as a textured structure is formed on a photoreceiving surface of a semiconductor substrate 1 of back electrode type solar cell 8, and an antireflection film 5 is formed to cover the concavo-convex structure. A passivation film 4 is formed on the back surface of semiconductor substrate 1 of back electrode type solar cell 8.

Back electrode type solar cell 8 includes semiconductor substrate 1, first conductivity type impurity diffusion regions 2 and second conductivity type impurity diffusion regions 3 formed on the back surface of semiconductor substrate 1, first conductivity type electrodes 6 formed to be in contact with first conductivity type impurity diffusion regions 2 and second conductivity type electrodes 7 formed to be in contact with second conductivity type impurity diffusion regions 3. Therefore, first conductivity type electrodes 6 corresponding to first conductivity type impurity diffusion regions 2 and second conductivity type electrodes 7 corresponding to second conductivity type impurity diffusion regions 3 are formed on the back surface side of semiconductor substrate 1.

First conductivity type electrodes 6 and second conductivity type electrodes 7 on the back surface side of back electrode type solar cell 8 have shapes protruding on the side opposite to semiconductor substrate 1 respectively, the electrode width of first conductivity type electrodes 6 and the electrode width of second conductivity type electrodes 7 continuously decrease as increasing distance from semiconductor substrate 1 respectively, and the outer surfaces of first conductivity type electrodes 6 and the outer surfaces of second conductivity type electrodes 7 are curved surfaces bent like side surfaces of columns respectively.

In this example, first conductivity type impurity diffusion regions 2 and second conductivity type impurity diffusion regions 3 are provided in the form of bands extending on the surface side and/or the back surface side of the plane of Fig. 1 respectively, and first conductivity type impurity diffusion regions 2 and second conductivity type impurity diffusion regions 3 are alternately arranged at prescribed intervals on the back surface of semiconductor substrate 1.

In this example, first conductivity type electrodes 6 and second conductivity type electrodes 7 are also provided in the form of bands extending on the surface side and/or the back surface side of the plane of Fig. 1 respectively, and first conductivity type electrodes 6 and second conductivity type electrodes 7 are formed to be in contact with first conductivity type impurity diffusion regions 2 and second conductivity type impurity diffusion regions 3 respectively along first conductivity type impurity diffusion regions 2 and second conductivity type impurity diffusion regions 3 on the back surface of semiconductor substrate 1 through openings provided in passivation film 4 respectively.

On the other hand, interconnection sheet 10 includes an insulating substrate 11, and first conductivity type wires 12 and second conductivity type wires 13 formed on the surface of insulating substrate 11.

First conductivity type wires 12 on insulating substrate 11 of interconnection sheet 10 are provided in shapes mutually opposed one by one to first conductivity type electrodes 6 on the back surface of back electrode type solar cell 8.

Second conductivity type wires 13 on insulating substrate 11 of interconnection sheet 10 are provided in shapes mutually opposed one by one to second conductivity type electrodes 7 on the back surface of back electrode type solar cell 8.

In this example, first conductivity type wires 12 and second conductivity type wires 13 of interconnection sheet 10 are also provided in the form of bands extending on the surface side and/or the back surface side of the plane of Fig. 1 respectively.

Aforementioned back electrode type solar cell 8 and aforementioned interconnection sheet 10 are bonded to each other by insulating resins 16 which are electric insulating resins set between back electrode type solar cell 8 and interconnection sheet 10, while first conductivity type electrodes 6 of back electrode type solar cell 8 and first conductivity type wires 12 of interconnection sheet 10 as well as second conductivity type electrodes 7 of back electrode type solar cell 8 and second conductivity type wires 13 of interconnection sheet 10 are electrically connected with each other by conductive substances 20 respectively.

Conductive substances 20 contain metals in contact with the respective ones of first conductivity type electrodes 6 and second conductivity type electrodes 7 of back electrode type solar cell 8 as well as first conductivity type wires 12 and second conductivity type wires 13 of interconnection sheet 10 without metallic bonding. In other words, portions where conductive substances 20 are in contact with these members may simply be constituted of at least the metals in contact with these members without metallic bonding in conductive substances 20.

While conductive substances 20 contain the metals in contact with the respective ones of first conductivity type electrodes 6, second conductivity type electrodes 7, first conductivity type wires 12 and second conductivity type wires 13 without metallic bonding in this embodiment, conductive substances 20 may simply contain metals in contact with at least any of first conductivity type electrodes 6, second conductivity type electrodes 7, first conductivity type wires 12 and second conductivity type wires 13 without metallic bonding in the present invention.

When the electrical connection between p electrodes 106 of back electrode type solar cell 80 and p wires 112 of interconnection sheet 100 and the electrical connection between n electrodes 107 of back electrode type solar cell 80 and n wires 113 of interconnection sheet 100 shown in Figs. 13(a) and 13(b) are attained by direct connection of directly bringing these into contact with each other without inserting any substances therebetween, the connection of these depends on the shapes of the electrodes (p electrodes 106 and n electrodes 107) of back electrode type solar cell 80 and 100 wires (p wires 112 and n wires 113) of the interconnection sheet, and hence electric contact areas have been small.

In the present invention, however, the electrical connection between first conductivity type electrodes 6 of back electrode type solar cell 8 and first conductivity type wires 12 of interconnection sheet 10 and the electrical connection between second conductivity type electrodes 7 of back electrode type solar cell 8 and second conductivity type wires 13 of interconnection sheet 10 are performed by conductive substances 20 in contact therewith without metallic bonding respectively, and mechanical connection between back electrode type solar cell 8 and interconnection sheet 10 is performed by insulating resins 16.

Thus, electric contact areas of the electrodes of back electrode type solar cell 8 and the wires of interconnection sheet 10 can be increased as compared with a case of employing direct connection of directly bringing the electrodes of back electrode type solar cell 8 and the wires of interconnection sheet 10 into contact with each other without inserting any substances therebetween, while the mechanical connection between back electrode type solar cell 8 and interconnection sheet 10 can be ensured by insulating resins 16.

In the present invention, therefore, contact resistance between the electrodes of the back electrode type solar cell and the wires of the interconnection sheet can be reduced while keeping the mechanical connection between the back electrode type solar cell and the interconnection sheet, whereby the solar cell module can have high characteristics.

In the present invention, further, formation of alloy layers (alloy layers of tin in solders and silver in silver electrodes, for example) causing reduction of reliability is suppressed between the back electrode type solar cell and the interconnection sheet to enable the electrical connection therebetween, whereby the reliability can be ensured longer.

While conductive substances 20 are not particularly restricted so far as the same contain the metals coming into contact with the electrodes of the back electrode type solar cell and the wires of the interconnection sheet to electrically connect these with each other without forming metallic bonds therewith respectively, hardened substances of melts of aggregating conductive particles are employed as conductive substances 20 in this embodiment. The particle sizes of the conductive particles are not particularly restricted so far as the conductive particles aggregate, and can be set to about 20 µm to 35 µm, for example. In the present invention, "aggregation" means that the distances between the conductive particles more diminish as a whole after the connection between the back electrode type solar cell and the interconnection sheet than before the connection between the back electrode type solar cell and the interconnection sheet.

As the hardened substances of the melts of the aggregating conductive particles, substances hardened after aggregates of conductive particles such as solder particles are melted or the like can be listed, for example. A substance containing at least either one of tin and bismuth can be employed as the material for the conductive particles, for example.

The hardness of conductive substances 20 is preferably lower than the hardness of at least any selected from a group consisting of first conductivity type electrodes 6, second conductivity type electrodes 7, first conductivity type wires 12 and second conductivity type wires 13, and more preferably lower than the hardness of all of first conductivity type electrodes 6, second conductivity type electrodes 7, first conductivity type wires 12 and second conductivity type wires 13. In this case, it tends to be capable of effectively suppressing breakage of the electrodes of back electrode type solar cell 8 and the wires of interconnection sheet 10 by conductive substances 20. The "hardness" means Vickers hardness (Hv).

As insulating resins 16, thermosetting resin such as generally known epoxy resin and/or photo-setting resin can be employed, for example. Additives such as generally known hardening agents may be contained in insulating resins 16, for example.

An example of a method for producing back electrode type solar cell 8 shown in Fig. 1 is now described with reference to schematic sectional views of Figs. 2(a) to 2(g).

First, semiconductor substrate 1 in which a slice damage 1a is formed on the surface of semiconductor substrate 1 is prepared by performing slicing from an ingot or the like, for example, as shown in Fig. 2(a). As semiconductor substrate 1, a silicon substrate consisting of polycrystalline silicon or single-crystalline silicon having a conductivity type of either an n type or a p type can be employed, for example.

Then, the slice damage 1 a is removed from the surface of semiconductor substrate 1, as shown in Fig. 2(b). The removal of slice damage 1a can be performed by etching the surface of the silicon substrate after the aforementioned slicing with mixed acid of an aqueous hydrogen fluoride solution and nitric acid or an aqueous alkaline solution such as sodium hydroxide, when semiconductor substrate 1 consists of the aforementioned silicon substrate, for example.

While the size and the shape of semiconductor substrate 1 after the removal of slice damage 1a are not particularly restricted either, the thickness of semiconductor substrate 1 can be set to at least 100 µm and not more than 500 µm, for example, and is particularly preferably set to about 200 µm.

Then, first conductivity type impurity diffusion regions 2 and second conductivity type impurity diffusion regions 3 are respectively formed on the back surface of semiconductor substrate 1, as shown in Fig. 2(c). First conductivity type impurity diffusion regions 2 can be formed by a method such as vapor phase diffusion employing gas containing a first conductivity type impurity or application diffusion of applying and thereafter heat-treating paste containing the first conductivity type impurity, for example. Second conductivity type impurity diffusion regions 3 can be formed by a method such as vapor phase diffusion employing gas containing a second conductivity type impurity or application diffusion applying and thereafter heat-treating paste containing the second conductivity type impurity, for example.

First conductivity type impurity diffusion regions 2 are not particularly restricted so far as the same are regions containing the first conductivity type impurity and exhibiting a conductivity type of an n type or a p type. As the first conductivity type impurity, an n-type impurity such as phosphorus, for example, can be employed if the first conductivity type is the n type, and a p-type impurity such as boron or aluminum, for example, can be employed if the first conductivity type is the p type.

Second conductivity type impurity diffusion regions 3 are not particularly restricted so far as the same are regions containing the second conductivity type impurity and exhibiting a conductivity type opposite to that of first conductivity type impurity diffusion regions 2. As the second conductivity type impurity, an n-type impurity such as phosphorus, for example, can be employed if the second conductivity type is the n type, and a p-type impurity such as boron or aluminum, for example, can be employed if the second conductivity type is the p type.

The first conductivity type may be a conductivity type of either the n type or the p type, and the second conductivity type may simply be a conductivity type opposite to the first conductivity type. In other words, the second conductivity type is the p type when the first conductivity type is the n type, and the second conductivity type is the n type when the first conductivity type is the p type.

As the gas containing the first conductivity type impurity, gas such as POCl₃, for example, containing an n-type impurity such as phosphorus can be employed if the first conductivity type is the n type, and gas such as BBr₃, for example, containing a p-type impurity such as boron can be employed if the first conductivity type is the p type.

As the gas containing the second conductivity type impurity, the gas such as POCl₃, for example, containing the n-type impurity such as phosphorus can be employed if the second conductivity type is the n type, and the gas such as BBr₃, for example, containing the p-type impurity such as boron can be employed if the second conductivity type is the p type.

Then, passivation film 4 is formed on the back surface of semiconductor substrate 1, as shown in Fig. 2(d). Passivation film 4 can be formed by a method such as thermal oxidation or plasma CVD (Chemical Vapor Deposition), for example.

While a silicon oxide film, a silicon nitride film or a laminate of a silicon oxide film and a silicon nitride film can be employed as passivation film 4, passivation film 4 is not restricted to this.

The thickness of passivation film 4 can be set to at least 0.05 µm and not more than 1 µm, for example, and is particularly preferably set to about 0.2 µm.

Then, the concavo-convex structure such as the textured structure is formed on the whole of the photoreceiving surface of semiconductor substrate 1, and antireflection film 5 is formed on the concavo-convex structure, as shown in Fig. 2(e).

The textured structure can be formed by etching the photoreceiving surface of semiconductor substrate 1, for example. If semiconductor substrate 1 is a silicon substrate, for example, the textured structure can be formed by etching the photoreceiving surface of semiconductor substrate 1 with an etching solution prepared by heating a liquid obtained by adding isopropyl alcohol to an aqueous alkaline solution such as sodium hydroxide or potassium hydroxide, for example, to at least 70°C and not more than 80°C, for example.

Antireflection film 5 can be formed by plasma CVD or the like, for example. While a silicon nitride film or the like, for example, can be employed as antireflection film 5, antireflection film 5 is not restricted to this.

Then, contact holes 4a and contact holes 4b are formed by partially removing passivation film 4 on the back surface of semiconductor substrate 1, as shown in Fig. 2(f). Contact holes 4a are formed to at least partially expose the surfaces of first conductivity type impurity diffusion regions 2, and contact holes 4b are formed to at least partially expose the surfaces of second conductivity type impurity diffusion regions 3.

Contact holes 4a and contact holes 4b can be respectively formed by a method of forming a resist pattern having openings in portions corresponding to portions for forming contact holes 4a and contact holes 4b on passivation film 4 by photolithography and thereafter removing passivation film 4 from the openings of the resist pattern by etching or the like, or a method of applying etching paste to portions of passivation film 4 corresponding to the portions for forming contact holes 4a and contact holes 4b and thereafter heating the same, for example.

Then, back electrode type solar cell 8 is prepared by forming first conductivity type electrodes 6 in contact with first conductivity type impurity diffusion regions 2 through contact holes 4a and second conductivity type electrodes 7 in contact with second conductivity type impurity diffusion regions 3 through contact holes 4b, as shown in Fig. 2(g).

As first conductivity type electrodes 6 and second conductivity type electrodes 7, electrodes made of a metal such as silver can be employed, for example.

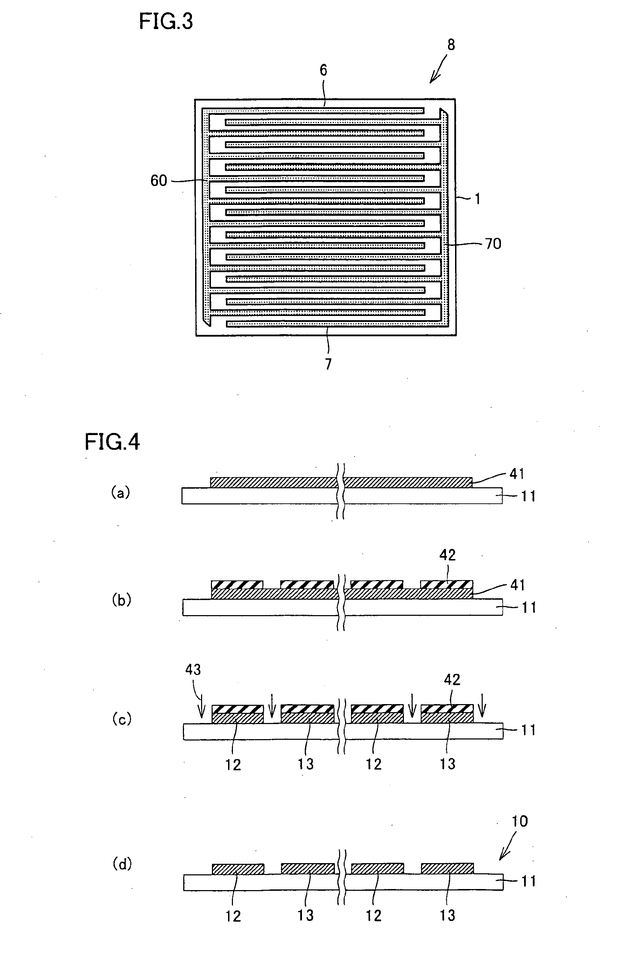

Fig. 3 shows a schematic plan view of an example of the back surface of back electrode type solar cell 8 shown in Fig. 1 prepared in the aforementioned manner. On the back surface of back electrode type solar cell 8, first conductivity type electrodes 6 and second conductivity type electrodes 7 are provided in the form of bands respectively. Plurality of band-shaped first conductivity type electrodes 6 are connected to one band-shaped first conductivity type collecting electrode 60 respectively, while plurality of band-shaped second conductivity type electrodes 7 are connected to one band-shaped second conductivity type collecting electrode 70 respectively. In this example, first conductivity type collecting electrode 60 is formed to extend in a direction perpendicular to the longitudinal direction of band-shaped first conductivity type electrodes 6, and second conductivity type collecting electrode 70 is formed to extend in a direction perpendicular to the longitudinal direction of band-shaped second conductivity type electrodes 7.

On the back surface of back electrode type solar cell 8 having the structure shown in Fig. 3, therefore, one comb-shaped electrode is formed by one first conductivity type collecting electrode 60 and plurality of first conductivity type electrodes 6, and one comb-shaped electrode is formed by one second conductivity type collecting electrode 70 and plurality of second conductivity type electrodes 7. First conductivity type electrodes 6 and second conductivity type electrodes 7 corresponding to comb-shaped teeth of the comb-shaped electrodes are arranged to face each other for meshing the comb-shaped teeth one by one with each other. One band-shaped first conductivity type impurity diffusion region 2 is arranged on a back surface portion of semiconductor substrate 1 with which each band-shaped first conductivity type electrode 6 is in contact, and one band-shaped second conductivity type impurity diffusion region 3 is arranged on a back surface portion of semiconductor substrate 1 with which each band-shaped second conductivity type impurity diffusion electrode 7 is in contact.

An example of a method for producing interconnection sheet 10 shown in Fig. 1 is now described with reference to schematic sectional views of Figs. 4(a) to 4(d).

First, a conductive layer 41 is formed on the surface of insulating substrate 11, as shown in Fig. 4(a). While a substrate made of resin of polyester, polyethylene naphthalate or polyimide, for example, can be employed as insulating substrate 11, insulating substrate 11 is not restricted to this.

The thickness of insulating substrate 11 can be set to at least 10 µm and not more than 200 µm, for example, and is particularly preferably set to about 25 µm.

While a layer made of a metal such as copper, for example, can be employed as conductive layer 41, conductive layer 41 is not restricted to this.

Then, a resist 42 is formed on conductive layer 41 on the surface of insulating substrate 11, as shown in Fig. 4(b). Resist 42 is provided in a shape having openings in portions other than portions leaving the wires of interconnection sheet 10 such as first conductivity type wires 12 and second conductivity type wires 13. A generally known substance can be employed as resist 42, and a substance prepared by hardening resin applied to a prescribed position by a method such as screen printing, dispenser application or ink jet application can be employed, for example.

Then, patterning of conductive layer 41 is performed by removing portions of conductive layer 41 exposed from resist 42 in a direction of arrow 43, and the wires of interconnection sheet 10 such as first conductivity type wires 12 and second conductivity type wires 13 are formed from the rest of conductive layer 41, as shown in Fig. 4(c).

The removal of conductive layer 41 can be performed by wet etching employing a solution of acid or alkali, for example.

Then, interconnection sheet 10 is prepared by entirely removing resist 42 from the surfaces of first conductivity type wires 12 and the surfaces of second conductivity type wires 13, as shown in Fig. 4(d).

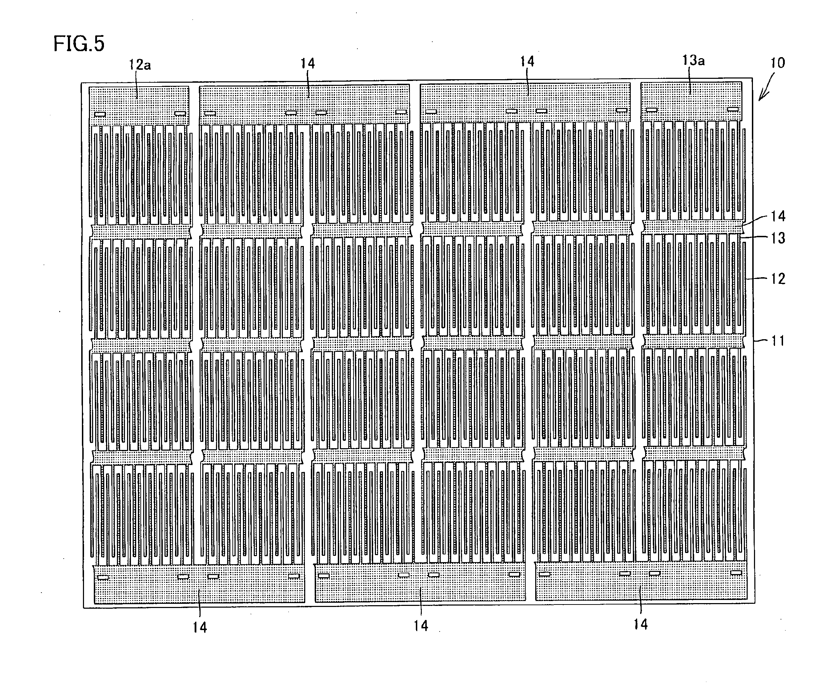

Fig. 5 shows a schematic plan view of an example of the surface of interconnection sheet 10 prepared in the aforementioned manner. On the surface of insulating substrate 11 of interconnection sheet 10, first conductivity type wires 12 and second conductivity type wires 13 are provided in the form of bands respectively. Band-shaped connecting wires 14 are formed on the surface of insulating substrate 11 of interconnection sheet 10, and first conductivity type wires 12 and second conductivity type wires 13 are electrically connected with each other by connecting wires 14. Connecting wires 14 can be formed from the rest of conductive layer 41 similarly to first conductivity type wires 12 and second conductivity type wires 13, for example.

Such a structure is so employed that adjacent first conductivity type wires 12 and second conductivity type wires 13 other than a comb-shaped first conductivity type wire 12a and a comb-shaped second conductivity type wire 13a positioned on terminals of interconnection sheet 10 respectively are electrically connected with each other by connecting wires 14, whereby it follows that back electrode type solar cells 8 set to be adjacent to each other on interconnection sheet 10 are electrically connected with each other. Therefore, it follows that all back electrode type solar cells 8 set on interconnection sheet 10 are electrically serially connected with each other.

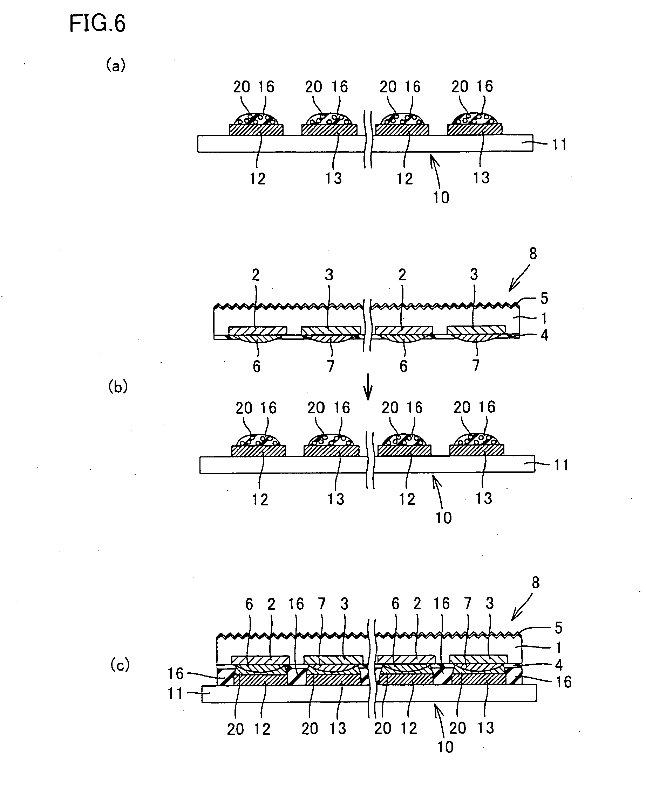

An example of a method for producing a solar cell with an interconnection sheet employed for the solar cell module shown in Fig. 1 is now described with reference to schematic sectional views of Figs. 6(a) to 6(c).

First, insulating resins 16 in which conductive substances 20 consisting of conductive particles are dispersed, for example, are applied onto the respective surfaces of first conductivity type wires 12 and second conductivity type wires 13 of interconnection sheet 10 produced in the aforementioned manner, as shown in Fig. 6(a).

Insulating resins 16 in which conductive substances 20 consisting of conductive particles are dispersed can be applied by a method such as screen printing, dispenser application or ink jet application, for example.

Then, back electrode type solar cell 8 is set on interconnection sheet 10, as shown in Fig. 6(b).

Back electrode type solar cell 8 is so set on interconnection sheet 10 that first conductivity type electrodes 6 of back electrode type solar cell 8 are set on first conductivity type wires 12 of interconnection sheet 10 and second conductivity type electrodes 7 of back electrode type solar cell 8 are set on second conductivity type wires 13 of interconnection sheet 10.

If insulating resins 16 consist of thermosetting resin, for example, insulating resins 16 and conductive substances 20 are heated thereby hardening insulating resins 16 and preparing melts by melting conductive substances 20 which are aggregating conductive particles.

If insulating resins 16 consist of photo-setting resin, for example, light such as ultraviolet light is applied to insulating resins 16 thereby hardening the same while conductive substances 20 are heated thereby preparing melts by melting conductive substances 20 which are aggregating conductive particles.

The heating of conductive substances 20 can be performed by heating conductive substances 20 to a temperature at which conductive substances 20 melt and the metals in conductive substances 20 do not form metallic bonds with the respective ones of first conductivity type electrodes 6, second conductivity type electrodes 7, first conductivity type wires 12 and second conductivity type wires 13, for example. Conductive substances 20 can follow the shape of at least any selected from the group consisting of first conductivity type electrodes 6, second conductivity type electrodes 7, first conductivity type wires 12 and second conductivity type wires 13 by melting conductive substances 20 due to the aforementioned heating of conductive substances 20.

When the aforementioned heating temperature for conductive substances 20 is a temperature of at least the setting temperature of insulating resins 16 in the case where insulating resins 16 consist of thermosetting resin, hardening of insulating resins 16 and melting of conductive substances 20 are preferably performed in the same step from the viewpoint of increasing production efficiency.

Through the aforementioned heating process after the setting of back electrode type solar cell 8, conductive substances 20 in insulating resins 16 applied onto the respective surfaces of first conductivity type wires 12 and second conductivity type wires 13 of interconnection sheet 10 aggregate on the respective surfaces of first conductivity type wires 12 and second conductivity type wires 13 of interconnection sheet 10, while it follows that insulating resins 16 partially move to regions between first conductivity type wires 12 and second conductivity type wires 13 of interconnection sheet 10.

Thereafter the melts of conductive substances 20 are cooled to room temperature, for example, and solidified, thereby electrically connecting first conductivity type electrodes 6 of back electrode type solar cell 8 and first conductivity type wires 12 of interconnection sheet 10 with each other and electrically connecting second conductivity type electrodes 7 of back electrode type solar cell 8 and second conductivity type wires 13 of interconnection sheet 10 with each other through hardened substances of the melts of conductive substances 20, as shown in Fig. 6(c), for example. Further, insulating resins 16 are hardened as described above, thereby mechanically connecting back electrode type solar cell 8 and interconnection sheet 10 with each other.

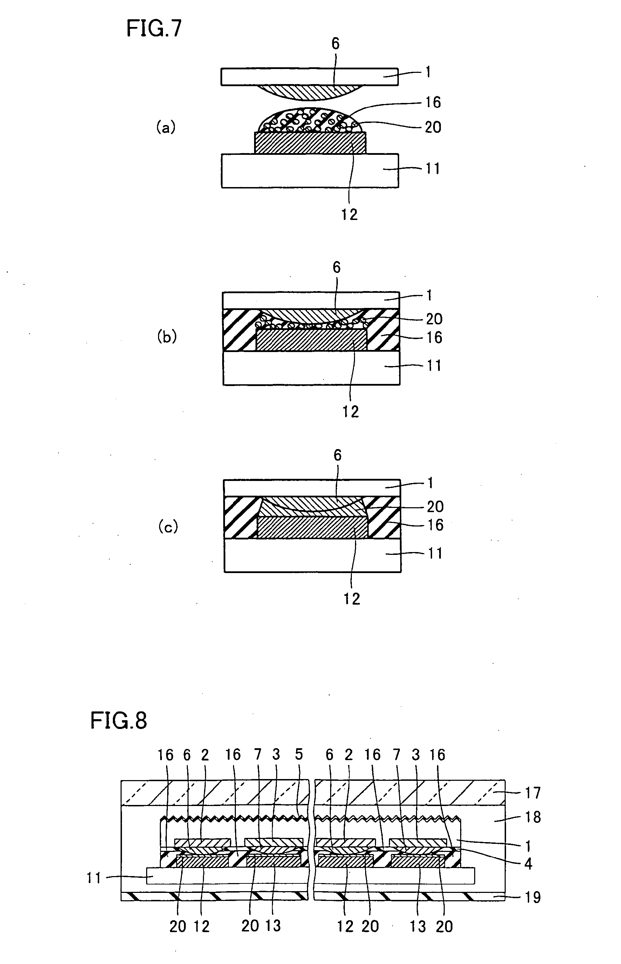

Figs. 7(a) to 7(c) show schematic enlarged sectional views illustrating an example of an electrical connecting method for first conductivity type electrodes 6 of aforementioned back electrode type solar cell 8 and first conductivity type wires 12 of interconnection sheet 10. Figs. 7(a) to 7(c) do not illustrate passivation film 4, for the convenience of illustration.

First, back electrode type solar cell 8 is so set that each first conductivity type electrode 6 of back electrode type solar cell 8 is positioned above the surface of each first conductivity type wire 12 coated with insulating resin 16 in which conductive substances 20 consisting of conductive particles are dispersed, as shown in Fig. 7(a).

Then, insulating resin 16 in which conductive substances 20 are dispersed is so heated that conductive substances 20 consisting of conductive particles aggregate in a region between each first conductivity type electrode 6 and each first conductivity type wire 12, as shown in Fig. 7(b).

Thereafter conductive substances 20 are heated to a temperature of at least a temperature at which conductive substances 20 melt and not more than a temperature at which conductive substances 20 do not form metallic bonds with the respective ones of first conductivity type electrode 6 and first conductivity type wire 12 and thereafter cooled. Thus, while conductive substances 20 are hardened to form a hardened substance after melting and forming a melt, conductive substances 20 are physically held between first conductivity type electrode 6 and first conductivity type wire 12 to be in contact therewith while changing the shape without forming metallic bonds with the respective ones of first conductivity type electrode 6 and first conductivity type wire 12, and it follows that the electrical connection between first conductivity type electrode 6 and first conductivity type wire 12 is attained.

While the electrical connection between each first conductivity type electrode 6 of back electrode type solar cell 8 and each first conductivity type wire 12 of interconnection sheet 10 has been described in the above, it goes without saying that the electrical connection between each second conductivity type electrode 7 of back electrode type solar cell 8 and each second conductivity type wire 13 of interconnection sheet 10 is also performed similarly to the above.

Thus, the example of the solar cell with an interconnection sheet according to the present invention is produced. With the solar cell with an interconnection sheet produced in the aforementioned manner, the example of the solar cell module according to the present invention shown in Fig. 1 is produced by sealing back electrode type solar cell 8, constituting the solar cell with an interconnection sheet, held between transparent substrate 17 such as a glass substrate including sealing material 18 such as ethylene vinyl acetate and back film 19 such as a polyester film including sealing material 18 in sealing material 18, as shown in Fig. 1, for example.

The aforementioned hardening of insulating resin 16 may be performed when sealing back electrode type solar cell 8 constituting the solar cell with an interconnection sheet in sealing material 18.

In the concept of the back electrode type solar cell in the present invention, not only that of the aforementioned structure in which both of the first conductivity type electrodes and the second conductivity type electrodes are formed only on one surface side (back surface side) of the semiconductor substrate, but also all of the so-called back-contact type solar cells (solar cells each having a structure of extracting current from a back surface side opposite to a photoreceiving surface side of the solar cell) such as an MWT (Metal Wrap Through) cell (solar cell having a structure in which electrodes are partially arranged in through-holes provided on a semiconductor substrate) are included.

In the concept of the solar cell with an interconnection sheet in the present invention, not only a structure in which a plurality of back electrode type solar cells are set on an interconnection sheet but also a structure in which one back electrode type solar cell is set on an interconnection sheet is included.

### <Second Embodiment>

Fig. 8 shows a schematic sectional view of another example of the solar cell module according to the present invention. The solar cell module according to this embodiment is characterized in a point that conductive substances 20 consisting of conductive films are held between first conductivity type electrodes 6 of a back electrode type solar cell 8 and first conductivity type wires 12 of an interconnection sheet 10 to be in contact therewith without being metallically bonded thereto so that first conductivity type electrodes 6 and first conductivity type wires 12 are electrically connected with each other while conductive substances 20 consisting of conductive films are held also between second conductivity type electrodes 7 of back electrode type solar cell 8 and second conductivity type wires 13 of interconnection sheet 10 to be in contact therewith without being metallically bonded thereto so that second conductivity type electrodes 7 and second conductivity type wires 13 are electrically connected with each other, as shown in Fig. 8, for example.

Also in this case, the electrical connection between first conductivity type electrodes 6 of back electrode type solar cell 8 and first conductivity type wires 12 of interconnection sheet 10 and the electrical connection between second conductivity type electrodes 7 of back electrode type solar cell 8 and second conductivity type wires 13 of interconnection sheet 10 are performed by conductive substances 20 in contact therewith without metallic bonding respectively, and mechanical connection between back electrode type solar cell 8 and interconnection sheet 10 is performed by insulating resins 16.

Thus, electrical contact areas of the electrodes of back electrode type solar cell 8 and the wires of interconnection sheet 10 can be increased also in this embodiment, whereby the solar cell module can have higher characteristics as compared with a conventional solar cell module.

Metal plating films or metal plates can be employed as the conductive films, for example. A substance containing at least one of tin and bismuth can be employed as the material for the conductive films, for example.

The metal plating films are formed on the surfaces of first conductivity type wires 12 and/or the surfaces of second conductivity type wires 13 by generally known electroplating or electroless plating, for example, to be held between the same and the electrodes of the unplated sides to be in contact therewith without metallic bonding.

Description of this embodiment other than the above is similar to that of the first embodiment, and hence the description is omitted.

### <Third Embodiment>

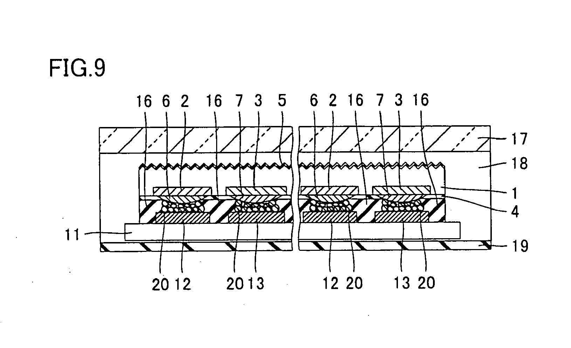

Fig. 9 shows a schematic sectional view of still another example of the solar cell module according to the present invention. The solar cell module according to this embodiment is characterized in a point that conductive substances 20 consisting of aggregates of conductive particles are held between first conductivity type electrodes 6 of a back electrode type solar cell 8 and first conductivity type wires 12 of an interconnection sheet 10 to be in contact therewith without metallic bonding so that first conductivity type electrodes 6 and first conductivity type wires 12 are electrically connected with each other while conductive substances 20 consisting of aggregates of conductive particles are held also between second conductivity type electrodes 7 of back electrode type solar cell 8 and second conductivity type wires 13 of interconnection sheet 10 to be in contact therewith without metallic bonding so that second conductivity type electrodes 7 and second conductivity type wires 13 are electrically connected with each other, as shown in Fig. 9, for example.

Also in this case, the electrical connection between first conductivity type electrodes 6 of back electrode type solar cell 8 and first conductivity type wires 12 of interconnection sheet 10 and the electrical connection between second conductivity type electrodes 7 of back electrode type solar cell 8 and second conductivity type wires 13 of interconnection sheet 10 are performed by conductive substances 20 in contact therewith without metallic bonding respectively, and mechanical connection between back electrode type solar cell 8 and interconnection sheet 10 is performed by insulating resins 16.

Thus, electrical contact areas of the electrodes of back electrode type solar cell 8 and the wires of interconnection sheet 10 can be increased also in this embodiment, whereby the solar cell module can have high characteristics.

The aggregates of the conductive particles are heat-treated at a temperature of such a degree that the aggregates of the conductive particles do not melt, so that the same can be held to be in contact without metallic bonding, for example.

The shapes of the conductive particles contained in the aggregates of the conductive particles are preferably spherical or flaky. Conductive particles of a plurality of types of shapes may be mixed into the aggregates of the conductive particles.

The sizes of the conductive particles are preferably larger as compared with surface roughness of the electrodes of back electrode type solar cell 8 and/or surface roughness of the wires of interconnection sheet 10. In this case, the conductive particles do not inhibit the electrical connection between the electrodes of back electrode type solar cell 8 and the wires of interconnection sheet 10 by entering recesses in the surfaces of the electrodes of back electrode type solar cell 8 and/or the surfaces of the wires of interconnection sheet 10, but the electrical connection therebetween can be more reliably performed.

Further, the sizes of the conductive particles are preferably smaller than the distances between adjacent electrodes of back electrode type solar cell 8 and/or the distances between adjacent wires of interconnection sheet 10. In this case, the adjacent electrodes of back electrode type solar cell 8 and/or the adjacent wires of interconnection sheet 10 can be inhibited from short-circuiting also in a case where the conductive particles are arranged between the adjacent electrodes of back electrode type solar cell 8 and/or the adjacent wires of interconnection sheet 10.

As to substances constituting the conductive particles, particles constituted of a metal such as copper, tin, copper, nickel or aluminum and/or particles whose surfaces are plated with a metal containing at least one of these can be employed, for example. Nonmetallic particles such as carbon particles containing graphite particles or the like can also be used as the conductive particles so far as the same are conductive substances.

Description of this embodiment other than the above is similar to that of the first embodiment, and hence the description is omitted.

### EXAMPLES

### <Example 1>

First, an n-type silicon substrate having a pseudo-square photoreceiving surface and a pseudo-square back surface having sides of 126 mm respectively with a thickness of 200 µm was prepared. Then, band-shaped n⁺ layers were formed by selectively diffusing phosphorus into the back surface of the n-type silicon substrate, while band-shaped p⁺ layers were formed by selectively diffusing boron into the back surface of the n-type silicon substrate. The band-shaped n⁺ layers and the band-shaped p⁺ layers were formed to be alternately arrayed on the back surface of the n-type silicon substrate respectively.

Then, silver electrodes (n electrodes) having curved surfaces so extending in a band-shaped manner that outer surfaces were bent like side surfaces of columns were formed on the n⁺ layers on the back surface of the n-type silicon substrate, while silver electrodes (p electrodes) having curved surfaces so extending in a band-shaped manner that outer surfaces were bent like side surfaces of columns were formed on the p⁺ layers. The thickness (distance up to the outer surfaces of the n electrodes in a direction perpendicular to the back surface of the n-type silicon substrate) of the silver electrodes was 9 µm, the surface roughness was ±3 µm, and the width was 100 µm.

An interconnection sheet in which copper wires (n wires and p wires) were formed on the surface of a polyester film as an insulating substrate was prepared as an interconnection sheet. The thickness of the copper wires was 35 µm, the surface roughness was ±3 µm, and the width was 550 µm. The distance between adjacent copper wires was 200 µm.

Then, epoxy resins in which Sn-Bi-based solder particles were dispersed were applied onto the respective surfaces of the copper wires (n wires and p wires) of the interconnection sheet prepared in the aforementioned manner.

Then, a back electrode type solar cell prepared in the aforementioned manner was set on the interconnection sheet, thereby aggregating the solder particles between the silver electrodes of the back electrode type solar cell and the copper wires of the interconnection sheet while partially moving the epoxy resins to regions between the copper wires.

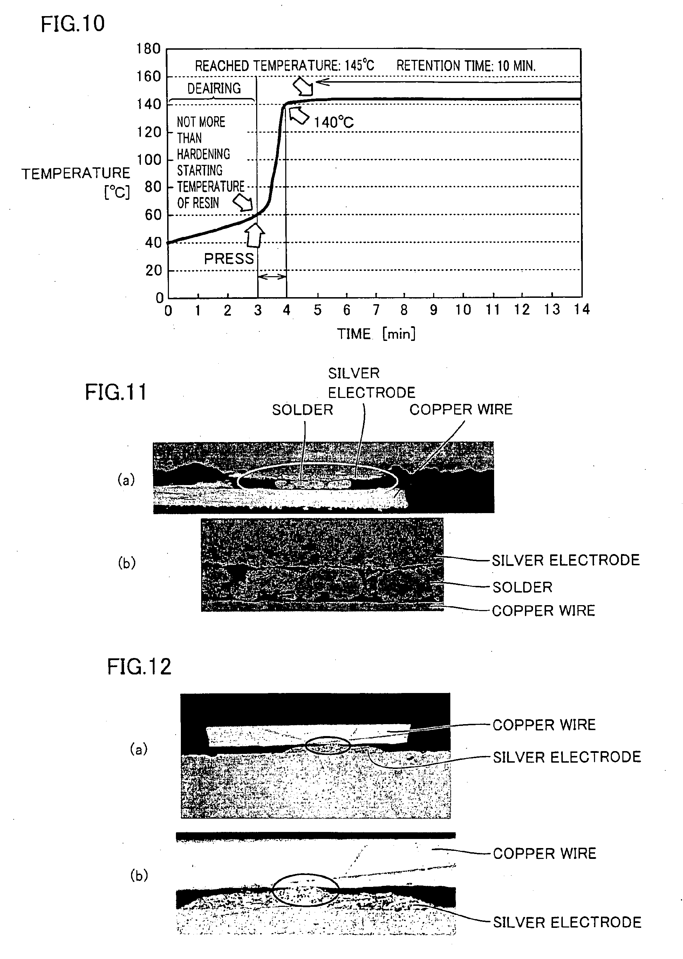

Thereafter the solder particles and the epoxy resins aggregating in a region between the back electrode type solar cell and the interconnection sheet were heat-treated with a prescribed heater in a heat profile shown in Fig. 10 respectively and thereafter cooled to room temperature. Thus, the aggregating solder particles melted without forming metallic bonds with the respective ones of the silver electrodes (n electrodes and p electrodes) of the back electrode type solar cell and the copper wires (n wires and p wires) of the interconnection sheet and thereafter hardened to form hardened substances while the epoxy resins hardened, whereby a solar cell with an interconnection sheet according to Example 1 was prepared.

The aforementioned heat treatment was performed as follows: First, pressure (press) was applied onto the back electrode type solar cell and the interconnection sheet while evacuating the gas inside the heater and the temperature in the heater was raised to 60°C which is a temperature of not more than a temperature at which hardening of the epoxy resins starts for three minutes, as shown in Fig. 10.

Then, the evacuation of the gas inside the heater was stopped, and the temperature in the heater was thereafter raised to 140°C in one minute, thereafter raised to 145°C in one minute, and kept at 145°C for 10 minutes, as shown in Fig. 10. Thereafter the temperature in the heater was cooled to room temperature (25°C).

Fig. 11(a) shows a microphotograph of connected portions of a silver electrode of the back electrode type solar cell and a copper wire of the interconnection sheet in the solar cell with an interconnection sheet according to Example 1, and Fig. 11(b) shows a microphotograph enlarging a portion surrounded by a white line in Fig. 11(a).

As shown in Figs. 11(a) and 11(b), it has been confirmed that hardened substances of melts of aggregating solder particles were held without forming metallic bonds with the respective ones of the silver electrode and the copper wire.

### <Comparative Example>

A solar cell with an interconnection sheet according to comparative example was prepared similarly to Example 1 except that the aforementioned heat treatment was performed as follows:
First, pressure (press) was applied onto a back electrode type solar cell and an interconnection sheet while evacuating the gas inside a heater and the temperature in the heater was raised to 60°C which is the temperature of not more than the temperature at which hardening of epoxy resins starts for three minutes.

Then, the evacuation of the gas inside the heater was stopped, and the temperature in the heater was thereafter raised to 140°C in one minute, thereafter raised to 160°C in one minute, and kept at 160°C for 10 minutes. Thereafter the temperature in the heater was cooled to room temperature (25°C).

Fig. 12(a) shows a microphotograph of connected portions of a silver electrode of the back electrode type solar cell and a copper wire of the interconnection sheet in the solar cell with an interconnection sheet according to comparative example, and Fig. 12(b) shows a microphotograph enlarging a portion surrounded by a white line in Fig. 12(a).

As shown in Figs. 12(a) and 12(b), it has been confirmed that hardened substances of melts of aggregating solder particles formed metallic bonds with the respective ones of the silver electrode and the copper wire.

### <Evaluation>

As obvious when comparing Figs. 11(a) and 11(b) and Figs. 12(a) and 12(b) with each other, contact areas between the hardened substances of the melts of the aggregating solder particles and the respective ones of the silver electrode and the copper wire increase in the solar cell with an interconnection sheet according to Example 1 as compared with the solar cell with an interconnection sheet according to comparative example, whereby the reliability of the solar cell with an interconnection sheet according to Example 1 and a solar cell module including the same can be ensured longer, and it is conceivable that the characteristics also rise.

### <Example 2>

First, a back electrode type solar cell and an interconnection sheet similar to those in Example 1 were prepared. Then, epoxy resins containing conductive particles, whose particle sizes were at least 12 µm and not more than 38 µm, constituted of tin, silver, copper and nickel were applied to the respective surfaces of copper wires (n wires and p wires) of the interconnection sheet.

Then, the back electrode type solar cell prepared in the aforementioned manner was set on the interconnection sheet, thereby holding the conductive particles between silver electrodes of the back electrode type solar cell and the copper wires of the interconnection sheet.

Thereafter the epoxy resins were heated to a temperature sufficient for hardening the same with a prescribed heater and the epoxy resins were thereafter cooled to room temperature. Thus, the conductive particles held between the back electrode type solar cell and the interconnection sheet came into contact with the respective ones of the silver electrodes (n electrodes and p electrodes) of the back electrode type solar cell and the wires (n wires and p wires) of the interconnection sheet with sufficient contact areas without forming metallic bonds and this state was kept by hardening of the epoxy resins, whereby a solar cell with an interconnection sheet shown in a microphotograph of Fig. 15 was prepared.

While the embodiments and Examples of the present invention have been described as above, proper combinations of the structures of the aforementioned respective embodiments and the respective Examples have also been planned from the first.

The embodiments and Examples disclosed this time must be considered as illustrative in all points and not restrictive. The range of the present invention is shown not by the above description but by the scope of claims for patent, and it is intended that all modifications within the meaning and range equivalent to the scope of claims for patent are included.

### INDUSTRIAL APPLICABILITY

The present invention can be utilized for a solar cell with an interconnection sheet, a solar cell module and a method for producing a solar cell with an interconnection sheet.

### REFERENCE SIGNS LIST

1 semiconductor substrate, 1a slice damage, 2 first conductivity type impurity diffusion region, 3 second conductivity type impurity diffusion region, 4 passivation film, 4a, 4b contact hole, 5 antireflection film, 6 first conductivity type electrode, 7 second conductivity type electrode, 11 insulating substrate, 12, 12a first conductivity type wire, 13, 13a second conductivity type wire, 8, 80 back electrode type solar cell, 10, 100 interconnection sheet, 41 conductive layer, 42 resist, 43 arrow, 60 first conductivity type collecting electrode, 70 second conductivity type collecting electrode, 101 n-type silicon substrate, 102 p⁺ layer, 103 n⁺ layer, 106 p electrode, 107 n electrode, 111 glass epoxy substrate, 112 p wire, 113 n wire, 119 solder, 121 alloy layer.

## Claims

1. A solar cell with an interconnection sheet, comprising:
a back electrode type solar cell (8); and
an interconnection sheet (10), wherein
said back electrode type solar cell (8) includes a semiconductor substrate (1) as well as a first conductivity type electrode (6) and a second conductivity type electrode (7) set on one surface side of said semiconductor substrate (1),
said interconnection sheet (10) includes an insulating substrate (11) as well as a first conductivity type wire (12) and a second conductivity type wire (13) set on one surface side of said insulating substrate (11),
at least either said first conductivity type electrode (6) and said first conductivity type wire (12) or said second conductivity type electrode (7) and said second conductivity type wire (13) are electrically connected with each other by a conductive substance (20), and
said conductive substance (20) contains a metal coming into contact with at least either the electrode (6, 7) or the wire (12, 13) without metallic bonding.

2. The solar cell with an interconnection sheet according to claim 1, wherein said conductive substance (20) contains at least one type selected from a group consisting of aggregating conductive particles, a hardened substance of a melt of aggregating conductive particles and a conductive film.

3. The solar cell with an interconnection sheet according to claim 1 or 2, wherein
the hardness of said conductive substance (20) is lower than the hardness of at least one selected from a group consisting of said first conductivity type electrode (6), said second conductivity type electrode (7), said first conductivity type wire (12) and said second conductivity type wire (13).

4. The solar cell with an interconnection sheet according to any of claims 1 to 3, wherein
said conductive substance (20) contains at least either one of tin and bismuth.

5. The solar cell with an interconnection sheet according to any of claims 1 to 4, wherein
insulating resin (16) is set between said back electrode type solar cell (8) and said interconnection sheet (10).

6. A solar cell module including the solar cell with an interconnection sheet according to any one of claims 1 to 5.

7. A method for producing a solar cell with an interconnection sheet comprising a back electrode type solar cell (8) including a first conductivity type electrode (6) and a second conductivity type electrode (7) set on one surface side of a semiconductor substrate (1) and an interconnection sheet (10) including a first conductivity type wire (12) and a second conductivity type wire (13) set on one surface side of an insulating substrate (11), comprising the steps of:
applying insulating resin (16) containing conductive particles to a surface of said first conductivity type wire (12) and a surface of said second conductivity type wire (13) of said interconnection sheet (10) respectively;
setting said first conductivity type electrode (6) of said back electrode type solar cell (8) on said first conductivity type wire (12) of said interconnection sheet (10) while setting said second conductivity type electrode (7) of said back electrode type solar cell (8) on said second conductivity type wire (13) of said interconnection sheet (10); and
electrically connecting at least either said first conductivity type electrode (6) and said first conductivity type wire (12) or said second conductivity type electrode (7) and said second conductivity type wire (13) with each other by said conductive particles coming into contact therewith without metallic bonding by applying pressure to at least either said back electrode type solar cell (8) or said interconnection sheet (10).
